# EUROPÄISCHE PATENTSCHRIFT

(11) **EP 0 897 181 B1**
(45) Veröffentlichungstag und Bekanntmachung des Hinweises auf die Patenterteilung: **27.08.2003**
(21) Anmeldenummer: 98111559.5
(22) Anmeldetag: 23.06.1998
(51) Int. Cl.: G11C 11/409, G11C 7/06

(54) **Schaltungsvorrichtung für die Bewertung des Dateninhalts von Speicherzellen**
Circuit for processing memory cell data
Circuit de traitement de données de cellules de mémoire

(30) Priorität: 13.08.1997 DE 19735137
(43) Veröffentlichungstag der Anmeldung: 17.02.1999
(73) Patentinhaber: Infineon Technologies AG, 81669 München (DE)
(72) Erfinder: Brede, Rüdiger, 85635 Höhenkirchen (DE); Savignac, Dominique, Dr., 85737 Ismaning (DE)
(74) Vertreter: Patentanwaltskanzlei WILHELM & BECK

(56) Entgegenhaltungen:
- EP-A- 0 350 860
- EP-A- 0 703 585
- US-A- 5 010 523
- US-A- 5 222 038
- PATENT ABSTRACTS OF JAPAN vol. 008, no. 027 (P-252), 4. Februar 1984 & JP 58 182192 A (NIPPON DENKI KK), 25. Oktober 1983

## Beschreibung

Die Erfindung betrifft eine Schaltungsvorrichtung für die Bewertung des Dateninhalts von Speicherzellen eines integrierten Halbleiterspeichers, welche Speicherzellen entlang von Bitleitungen und Wortleitungen angeordnet sind.

Ein wesentliches Problem bei der Entwicklung und im Betrieb eines DRAM stellt die Rückgewinnung der Information aus einer Speicherzelle dar. Zum Einen ist die Information in einer Zelle durch eine extrem kleine Kapazität repräsentiert, zum Anderen wird diese Kapazität oft noch durch unterschiedlichste Einflüsse reduziert. Diese kleine Ladungsmenge gilt es so zu verstärken, dass die richtige Information rekonstruiert werden kann.

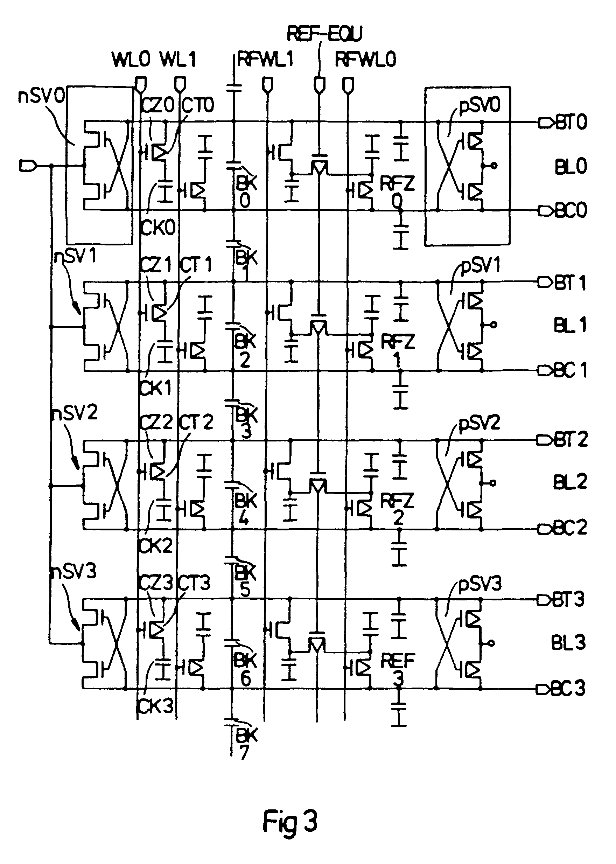

Eine bekannte Schaltungsvorrichtung der gattungsgemäßen Art wird unter Bezugnahme auf Figur 3 erläutert, welche einen Ausschnitt aus dem Zellenfeld eines DRAM-Halbleiterspeichers zeigt. Dargestellt sind vier Bitleitungspaare BL0, BL1, BL2, BL3 bestehend jeweils aus True-Bitleitungshälften BT0, BT1, BT2, BT3, und Complement-Bitleitungshälften BC0, BC1, BC2, BC3. Jede Speicherzelle CZ0, CZ1, CZ2, CZ3 besitzt eine Zellkapazität CK0, CK1, CK2, CK3, die jeweils an einem Auswahltransistor CT0, CT1, CT2, CT3 angeschlossen ist, über den die Ladungen hinein bzw. heraus gelangen. Jede Zellkapazität ist hierbei mit dem Auswahltransistor über dessen Drainanschluß bzw. Sourceanschluß an der entsprechenden Bitleitungshälfte und über dessen Gateanschluß an einer Wortleitung angeschlossen. Jeder Auswahltransistor CT wird durch eine entsprechende Wortleitung WL0, WL1, ...WL255 ein- bzw. ausgeschaltet. Eine Wortleitung korrespondiert dabei immer mit einer Bitleitungshälfte.

Zu einem Bitleitungspaar gehören je ein p-Kanal-Sense-Verstärker pSV und ein n-Kanal-Sense-Verstärker nSV, welche dem Zweck dienen, das nach Aktivieren der entsprechenden Wortleitung WL auf die entsprechende Bitleitungshälfte geschaltete Zellsignal so zu verstärken, dass eine EINS und eine NULL eindeutig unterschieden werden kann. Die Information von und nach der Zelle fließt über die Bitleitung, an die der Auswahltransistor mit angeschlossen ist. Beim Schreiben gibt es keine Probleme, da hier die Ladung durch die Spannungsversorgung immer maximal der Zelle angeboten wird. Beim Lesen wird nun die Zelle auf die Bitleitung geschaltet. Dadurch ändern sich die Ladungsverhältnisse auf eben dieser Bitleitung. Durch Aktivierung der Sense-Verstärker pSV und nSV wird nun die Ladungsänderung so verstärkt, dass eine EINS oder NULL erkennbar wird. Mit der Aktivierung einer Wortleitung werden alle Zellen dieser Wortleitung an die zugehörigen Bitleitungen geschaltet. Somit wird die Spannung auf der Bitleitung durch die Ladung, die von der Zelle auf die Bitleitung fließt, beeinflusst. Der Einfluss auf die Bitleitungsspannung ist entsprechend dem Kapazitätsverhältnis Zelle zu Bitleitung (etwa 1 : 5) sehr klein. Zwischen allen Bitleitungen befinden sich parasitäre BL-BL-Kapazitäten BK0, BK1, BK2, BK3, BK4, BK5, BK6, BK7.

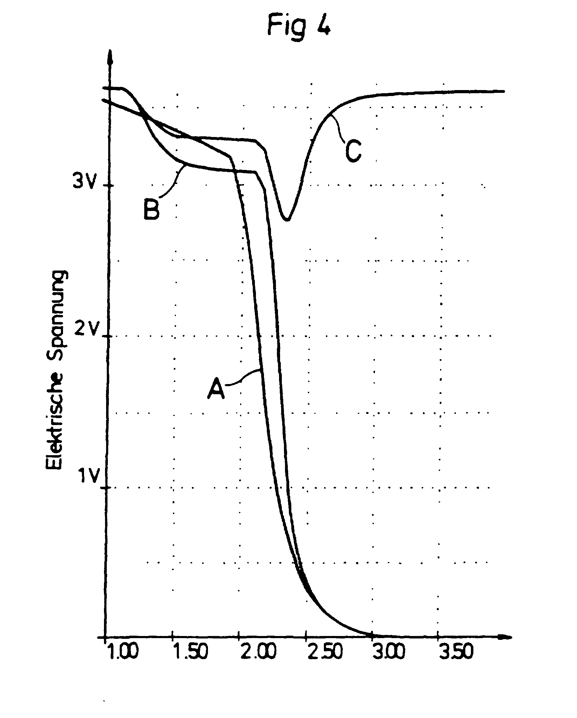

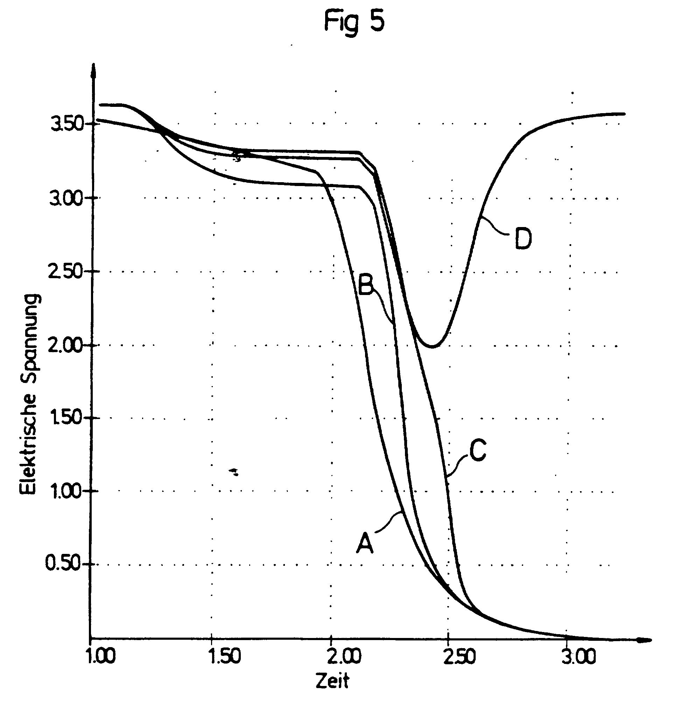

Im Einzelnen ist ein Lesevorgang wie folgt. Während einer Precharge-Zeit werden die Bitleitungen auf eine definierte Spannung vorgeladen, beispielsweise auf VDD = 3,6 V. Daran anschließend wird beim Lesen eine Wortleitung aktiv geschaltet, beispielsweise die Wortleitung WL0. Angenommen, in den Zellen CZ0, CZ1, CZ2 und CZ3 stehen jeweils NULLen. Die Normalspannung für eine NULL ist beispielsweise 1,2 V, die Normalspannung für eine EINS ist 3,6 V, die Normalspannung der Referenzzelle RFZ beträgt dann in etwa 2,6 V. Im Folgenden wird nun angenommen, dass die Zelle CZ2 eine schwache Zelle ist, beispielsweise verursacht durch einen hohen Leckstrom und daher eine NULLspannung von 2,2 V besitzt (bei einer anderen Annahme wäre beispielsweise die Kapazität der Zelle CZ2 etwas kleiner als der Zellkapazitätsdurchschnitt. Eine solche Annahme würde zu ähnlichen Ergebnissen führen). Figur 4 zeigt eine Simulation der Bewertung (Lesen) einer normalen NULL (1,2 V), und Figur 5 die Simulation der Bewertung einer schwachen NULL (2,2 V) der Zelle CZ2. Dargestellt ist jeweils der Verlauf der Spannung in Volt in Abhängigkeit der Zeit (willkürliche Einheiten). Die Kurve A zeigt den Spannungsverlauf des Signals SETN, welches die Bewertung startet. Die Kurve B zeigt den Spannungsverlauf der Bitleitungen BT0, BT1, BT3, die mit einer Zelle verbunden sind, in denen eine Normalnull (1,2 V) gespeichert ist. Die Kurve C zeigt den Spannungsverlauf der Bitleitungen BC0, BC1, BC3, die mit den Referenzzellen RFZ0, RFZ1, RFZ3 (2,6 V) verbunden sind. In Figur 5 bezeichnet die Kurve D den Spannungsverlauf der Bitleitung BT2, die mit der Zelle CZ2 verbunden ist, in der eine schwache NULL (2,2 V) gespeichert ist. Man erkennt aus der Simulation nach Figur 5, dass die schwache NULL der Zelle CZ2 falsch bewertet wird, da die Bitleitung BT2 während der Bewertung auf 3,6 V heraufgeht, obwohl die Spannung der Referenzzelle RFZ2 um 0,4 Volt größer ist (2,6 V). Die Ursache für diese falsche Bewertung liegt in den parasitären BL-BL-Kapazitäten BK. Gemäß Figur 5 zieht die Bitleitung BT3 gewissermaßen während der Bewertung über die parasitäre BL-BL-Kapazität BK5 an der Bitleitung BC2. Dadurch wird auf die Bitleitung BC2 eine negative Spannung eingekoppelt, durch welche die Spannung von BC2 unterhalb der Spannung von BT2 sinkt, wodurch letztendlich eine falsche Bewertung entsteht.

In vielen bisher bekannten Entwürfen werden die bei einer Bewertung des Zellsignals (Sensing) auf den benachbarten Bitleitungen infolge von kapazitiven Kopplungen entstehenden Störungen toleriert. Diese Entwürfe erfordern jedoch eine größere Zellkapazität. Andere Entwürfe verwenden sogenannte twisted Bitlines, welche jedoch wertvolle Chipfläche beanspruchen.

Aus der Druckschrift US 5,010,523 ist ein Ausleseschaltkreis für ein DRAM bekannt, bei dem die Bitleitungen zeitweilig mit einer großen Kapazität oder Spannungsquelle verbunden werden, wenn eine Leseoperation durchgeführt wird. Dies erfolgt, indem beim Auslesen die Bitleitung eines Bitleitungspaares, die nicht mit der auszulesenden Speicherzelle verbunden ist, mit den Bitleitungen anderer Bitleitungspaare, an denen ebenfalls keine auszulesende Speicherzelle anliegt, verbunden werden. Auf diese Weise wird die Kapazität der nicht mit den Speicherzellen verbundenen Bitleitungen erhöht und gleichzeitig das Potential im Wesentlichen auf dem Mittenpotential gehalten. Der Erfindung liegt daher die Aufgabe zugrunde, eine Schaltungsvorrichtung der gattungsgemäßen Art dahingehend zu verbessern, dass eine sichere Bewertung auch schwacher Speicherzellen ermöglicht ist, ohne die Zellkapazität zu vergrößern, oder besonders angeordnete Bitleitungen, die zusätzliche Chipfläche erfordern, zu verwenden.

Diese Aufgabe wird durch eine Schaltungsvorrichtung nach Anspruch 1 gelöst.

Erfindungsgemäß ist eine Spannungskompensationseinrichtung mit Spannungskompensationselementen vorgesehen ist, die im Sinne einer spannungsmäßigen Kopplung jeweils zweier benachbarter Bitleitungen geschaltet sind. Dem Prinzip der Erfindung folgend weist das Spannungskompensationselement insbesondere einen den beiden Bitleitungen zugeordneten elektrischen Kompensationswiderstand auf. Bei einer bevorzugten Ausführung ist das Spannungskompensationselement so ausgebildet bzw. angeordnet und/oder derart gesteuert, und damit die an dem Spannungskompensationselement abfallende Kompensationsspannung so eingestellt, dass eine sehr schwache NULL bzw. sehr schwache EINS als Dateninhalt einer betroffenen Speicherzelle von der Schaltungsvorrichtung noch als digitale NULL bzw. EINS bewertet ist.

Hierbei weisen die Spannungskompensationselemente von Vorteil Transistoren auf, deren eine Elektrodenanschlüsse (Drain bzw. Source) mit benachbarten Bitleitungen gekoppelt sind, und deren andere Elektrodenanschlüsse (Drain bzw. Source) gemeinsam mit dem elektrischen Kompensationswiderstand verbunden sind. Von Vorteil können die Transistoren der Spannungskompensationselemente gleichzeitig Bestandteile der Senseverstärkereinrichtung sein. Dem Prinzip der Erfindung folgend ist das Spannungskompensationselement derart eingestellt, dass die Spannungskompensation für alle möglichen Bitmuster auf den Bitleitungen gute Ergebnisse liefert.

Vorteilhafte Weiterbildungen der Erfindung ergeben sich aus den Unteransprüchen.

Nachfolgend wird die Erfindung anhand eines in der Zeichnung dargestellten Ausführungsbeispiels weiter erläutert. Im Einzelnen zeigen die schematischen Darstellungen in:
- Figur 1A: einen Ausschnitt aus einem Zellenfeld einer synchronen DRAM-Halbleiterspeichereinrichtung mit einer Schaltungsvorrichtung für die Bewertung des Dateninhalts von Speicherzellen nach einem ersten Ausführungsbeispiel der Erfindung;
- Figur 1B: einen Ausschnitt aus einem Zellenfeld einer synchronen DRAM-Halbleiterspeichereinrichtung mit einer Schaltungsvorrichtung nach einem zweiten Ausführungsbeispiel der Erfindung;
- Figur 2: den zeitlichen Spannungsverlauf beim Lesen einer schwachen NULL mit der erfindungsgemäßen Schaltungsvorrichtung nach Figur 1A oder 1B;
- Figur 3: einen schematischen Ausschnitt aus einem Zellenfeld einer bisherigen DRAM-Halbleiterspeichereinrichtung;
- Figur 4: die Simulation einer Bewertung einer normalen NULL; und
- Figur 5: die Simulation der Bewertung einer schwachen NULL vermittels einer bisherigen Schaltungsvorrichtung.

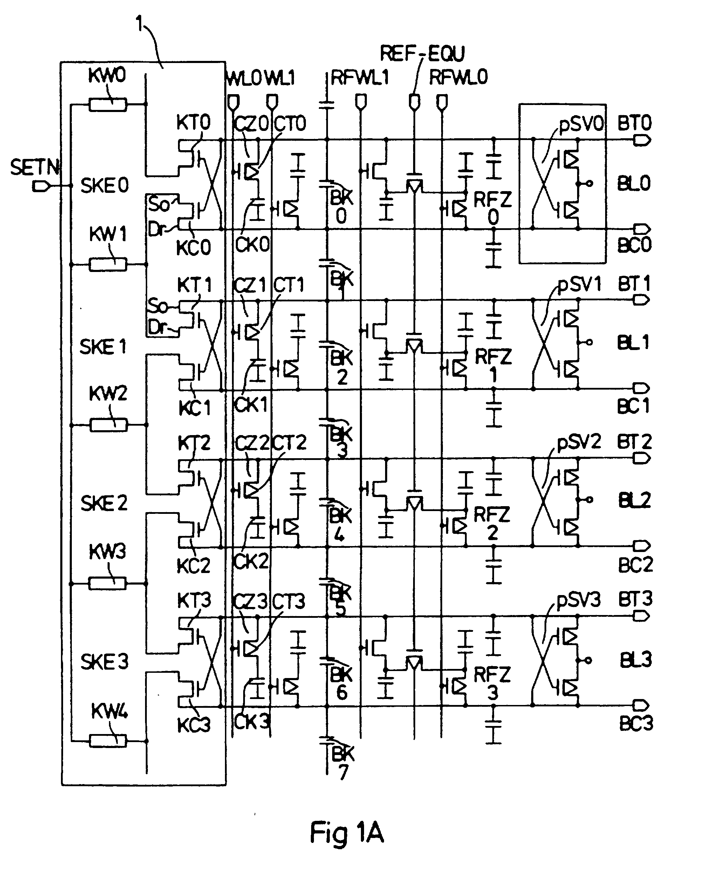

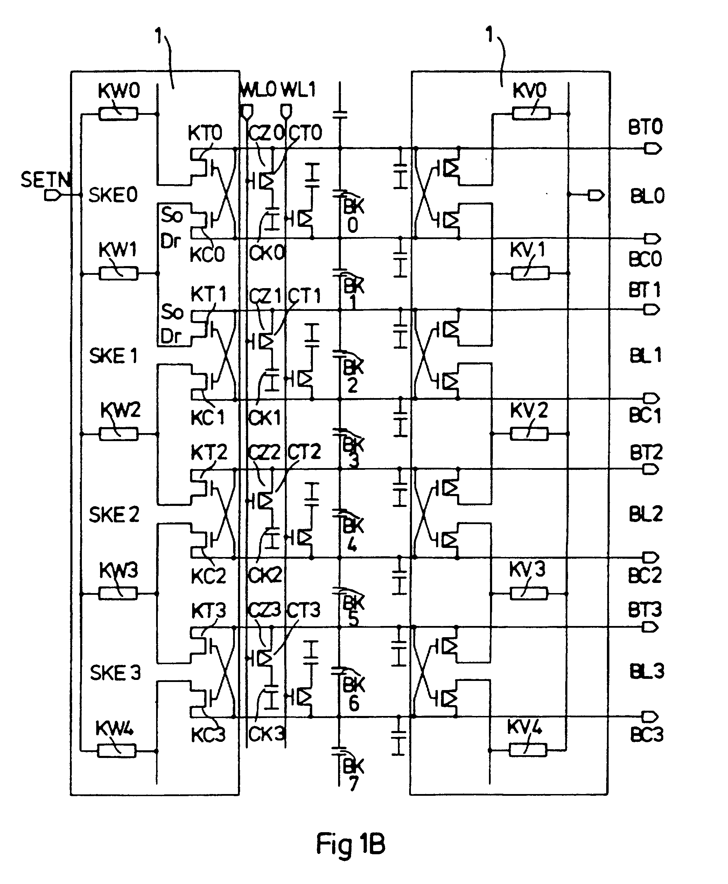

Bei den in den Figuren 1A und 1B dargestellten Ausführungsbeispielen einer erfindungsgemäßen Schaltungsvorrichtung bezeichnen gleiche Bezugsziffern gleiche Komponenten wie bei der eingangs gemäß Figur 3 beschriebenen Schaltung, so dass deren Erläuterung nicht wiederholt wird. Im Unterschied zur Anordnung nach Figur 3 und entsprechend dem Wesen der Erfindung besitzt die Schaltungsvorrichtung nach Figur 1A bzw. 1B eine Kompensationseinrichtung 1 mit Spannungskompensationselementen SKE0, SKE1, SKE2, SKE3, die im Sinne einer spannungsmäßigen Kopplung jeweils zweier benachbarter Bitleitungen wie dargestellt geschaltet sind. Im Einzelnen besitzt - am Beispiel der Bitleitung BL1, analoges gilt für jede weitere Bitleitung - das Spannungskompensationselement SKE1 einen den beiden aufeinanderfolgenden, benachbarten Bitleitungen BL1 und BL0 zugeordneten elektrischen Kompensationswiderstand KW1, und Transistoren KC0 und KT1, deren eine Elektrodenanschlüsse (Drain von KC0 bzw. Source von KT1) mit benachbarten Bitleitungen gekoppelt sind, und deren andere Elektrodenanschlüsse (Drain KT1 bzw. Source von KC0) gemeinsam mit dem elektrischen Kompensationswiderstand KW1 verbunden sind. Insbesondere ist ein der Bitleitung BL1 zugeordneter n-Kanal-Enhancement-MOSFET-Transistor KT1 vorgesehen, dessen Source-Anschluss So mit der dazugehörenden True-Bitleitungshälfte BT1, und dessen Drain-Anschluss Dr mit dem Widerstand KW1, und dessen Gate-Anschluss Ga mit der komplementären Complement-Bitleitungshälfte BC1 verbunden ist. Sämtliche n-Kanal-Enhancement-MOSFET-Transistoren KT und KC besitzen jeweils eine Einsatzspannung von etwa 0,6 V.

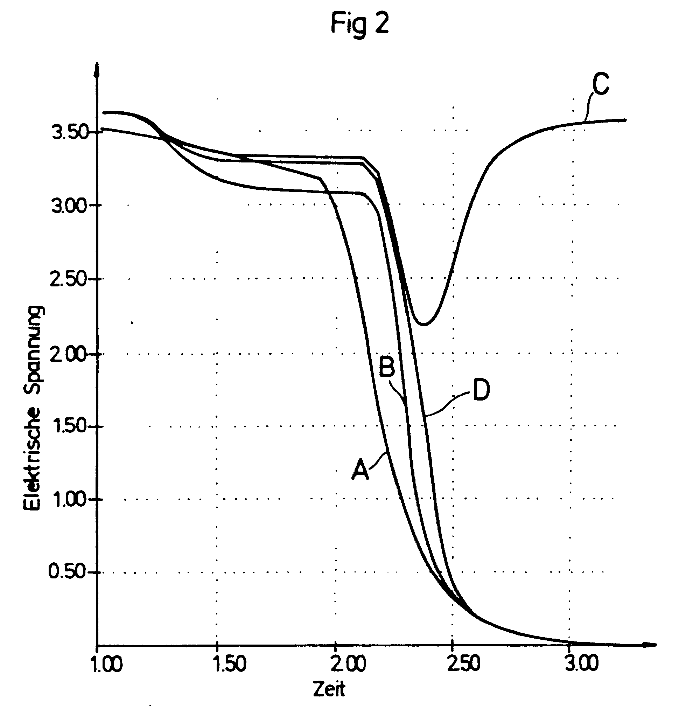

Die Funktionsweise der erfindungsgemäßen Schaltungsvorrichtung nach Figur 1 geht aus der schematischen Bewertungsdarstellung einer schwachen NULL gemäß Figur 2 hervor. Die Kurve A bezeichnet wiederum den Spannungsverlauf des Signals SETN, die Kurve B den auf den Bitleitungen BT1 und BT3 gemessenen Spannungsverlauf, die Kurve C den auf der Bitleitung BC2 gemessenen Spannungsverlauf, und die Kurve D den Spannungsverlauf der Bitleitung BT2, die mit einer Speicherzelle CZ2 verbunden ist, in der eine schwache NULL (2,2 V) gespeichert ist. Wie aus Figur 2 ersichtlich ist, wird die schwache NULL der Speicherzelle CZ2 (2,2 V Zellspannung) nun richtig bewertet, d.h. die Bitleitung BT2 geht auf Null V. Die Bitleitung BT3 zieht auch jetzt während der Bewertung über die parasitäre BL-BL-Kapazität BK5 an der Bitleitung BC2. Bei der erfindungsgemäßen Schaltungsvorrichtung fließt der Strom von der Bitleitung BT3 über den Transistor KT3 und damit über den Widerstand KW3 und ruft an diesem einen Spannungsabfall hervor. Dieser Spannungsabfall führt zu einer Reduzierung der Gate-Source-Spannung von Transistor KC2 und kompensiert die von - BT3 auf BC2 (über BK5) gekoppelte negative Spannung, die zu einer Reduzierung der Gate-Source-Spannung von Transistor KT2 führt. Der Widerstand KW3, und entsprechend die Widerstände KW2, KW1 usw., muß somit so dimensioniert sein, dass der bei der Bewertung fließende Strom an ihm einen Spannungsabfall hervorruft, der die über die parasitäre BL-BL-Kapazität BK5 eingekoppelte Spannung kompensiert, jedoch nicht überkompensiert. Eine Überkompensation würde vorliegen, wenn eine schwache EINS (2,7 V Zellspannung bei einer Referenzzellspannung von 2,6 V) als NULL bewertet würde.

Die vorstehend erläuterte Spannungskompensation sollte für alle möglichen Bitmuster auf den Bitleitungen gute Ergebnisse liefern:

**Tabelle 1:**

| mögliche Bitmuster relativ zur Bitleitung BT2 (nach Figur 1). | | | | | | |
|---|---|---|---|---|---|---|
| **Nummer** | **BC3** | **BT3** | **BC2** | **BT2** | **BC1** | **BT1** |
| 1. | ½ | 0 | ½ | "0" | ½ | 0 |
| 2. | ½ | 0 | ½ | "0" | ½ | 1 |
| 3. | ½ | 1 | ½ | "0" | ½ | 0 |
| 4. | ½ | 1 | ½ | "0" | ½ | 1 |
| 5. | ½ | 0 | ½ | "1" | ½ | 0 |
| 6. | ½ | 0 | ½ | "1" | ½ | 1 |
| 7. | ½ | 1 | ½ | "1" | ½ | 0 |
| 8. | ½ | 1 | ½ | "1" | ½ | 1 |

Hierbei bezeichnen die in der Tabelle verwendeten 0, "0", ½, 1, "1" das folgende:
0 bedeutet: auf die betreffende Bitleitungshälfte wird eine Zelle geschaltet, in der eine NULL steht.
"0" bedeutet: auf die betreffende Bitleitungshälfte (BT2) wird eine Zelle geschaltet, in der eine schwache NULL steht.
½ bedeutet: auf die betreffende Bitleitungshälfte wird eine Referenzzelle geschaltet.
1 bedeutet: auf die betreffende Bitleitungshälfte wird eine Zelle geschaltet, in der eine EINS steht.
"1" bedeutet: auf die betreffende Bitleitungshälfte (BT2) wird eine Zelle geschaltet, in der eine schwache EINS steht.

Das Bitmuster 1. nach der Tabelle 1 entspricht dem obig ausführlich untersuchten Fall, für den mit der Schaltungsvorrichtung nach Figur 1 die kapazitive BL-BL-Störung kompensiert wurde. Bei dem Bitmuster 2. neutralisieren sich die kapazitiven BL-BL-Störungen auf die Bitleitung 2, da die Störung von BT3 auf BC2 gleich der Störung von BC1 auf BT2 ist (BT3 und BC1 gehen auf Null). Bei dem Bitmuster 3. neutralisieren sich die kapazitiven BL-BL-Störungen auf die Bitleitung 2 ebenfalls bzw. sind annähernd Null (BT3 und BC1 bleiben auf Eins). Das Bitmuster 4. verhält sich ähnlich wie das Bitmuster 1. Die "Störung" von BC1 auf BT2 (BC1 geht auf Null und hilft der schwachen NULL auf BT2) wird kompensiert. Für die Bitmuster 5. bis 8. gelten ähnliche Zusammenhänge.

Die Schaltungsvorrichtung nach Figur 1A oder 1B kompensiert somit die kapazitiven Kopplungen zwischen benachbarten Bitleitungen während der Bewertung durch Spannungsabfälle an Widerständen, die entsprechend Figur 1A oder 1B angeordnet sind.

Mit der Erfindung werden auch noch sehr schwache NULLen (Zellspannung 2,5 V und weniger) richtig bewertet. Analoges gilt für schwache EINSEN. Der Zellspannungsgewinn beträgt etwa 0,4 V. Die Differenzspannung zwischen einer starken NULL (1,2 V) und der Referenzzellspannung (2,6 V) beträgt 1,4 V. Mit der Schaltungsvorrichtung nach Fig. 3 sind davon aber nur 0,9 V nutzbar (die Null fällt bei der Schaltungsvorrichtung nach Figur 3 schon bei einer Zellspannung von 2,2 V aus). Mit der erfindungsgemäßen Schaltungsvorrichtung nach Figur 1 vergrößert sich hingegen der nutzbare Spannungsbereich auf 1,3 V; die NULL wird noch bei 2,5 V richtig bewertet. Der nutzbare Spannungsbereich vergrößert sich also um etwa 44 %, wobei dieser Wert von der Größe der parasitären BL-BL-Kapazität und der Größe der parasitären Bitleitungskapazität abhängig ist. Je größer das Verhältnis von der parasitären BL-BL-Kapazität zur parasitären Bitleitungskapazität ist, desto größer ist die durch Spannungskompensation erzielbare Verbesserung bei der Bewertung.

Bei dem in Figur 1A dargestellten Ausführungsbeispiel sind jeder Bitleitung Referenzzellen RFZ zugeordnet, und zwar jeweils für eine Gruppe von beispielsweise 256 Wortleitungen WL0 bis WL255. Diese Referenzzellen dienen in an sich bekannter Weise der Einstellung einer mittleren Referenzspannung beim Lesevorgang durch die Senseverstärker. Die erfindungsgemäße Spannungskompensationsschaltung lässt sich in gegebenenfalls leicht modifizierter Anordnung auch in solchen Entwürfen anwenden, bei denen die Bitleitungen nur auf die halbe Array-Spannung vorgeladen werden (beispielsweise VDD/2), und in denen daher keine Referenzzellen notwendig sind. Eine solche Ausführung zeigt Figur 1B. In diesem Fall nimmt der p-Senseverstärker "aktiv" an der Bewertung teil und bringt während der Bewertung eine der Bitleitungen (BT oder BC) von z.B. VDD/2 auf VDD. Die Widerstände KV0, KV1, KV2, KV3 sorgen dabei ähnlich wie die Widerstände KW1, ... für eine Kompensation der über die parasitäen BL-BL-Kapazitäten eingekoppelten Spannungen.

Als weiteren Vorteil könnten bei einer Anwendung der erfindungsgemäßen Spannungskompensationsanordnung die Zellkapazitäten reduziert werden; alternativ könnte man bei unveränderter Zellkapazität eine verbesserte Retentions-Zeit erhalten.

## Patentansprüche

1. Schaltungsvorrichtung für die Bewertung des Dateninhalts von Speicherzellen (CZ) eines integrierten Halbleiterspeichers, welche Speicherzellen entlang von Bitleitungen (BL) und Wortleitungen (WL) angeordnet sind,
wobei jede Bitleitung aus einem Paar komplementärer Bitleitungshälften (BT, BC) besteht, die gemeinsam an eine Sense-Verstärkereinrichtung angeschlossen sind,
**dadurch gekennzeichnet,**
**dass** eine Spannungskompensationseinrichtung (1) mit Spannungskompensationselementen (SKE) vorgesehen ist, die im Sinne einer spannungsmäßigen Kopplung jeweils zweier benachbarter Bitleitungen (BL) geschaltet sind,
wobei die Spannungskompensationselemente an die komplementären Bitleitungshälften der zwei benachbarten Bitleitungen angeschlossen sind.

2. Schaltungsvorrichtung nach Anspruch 1,
**dadurch gekennzeichnet,**
**dass** das Spannungselement (SKE) einen den beiden Bitleitungen zugeordneten elektrischen Kompensationswiderstand (KW, KV) aufweist.

3. Schaltungsvorrichtung nach Anspruch 1 oder 2,
**dadurch gekennzeichnet,**
**dass** das Spannungskompensationselement (SKE) so ausgebildet bzw. angeordnet und/oder derart gesteuert ist und damit die an dem Spannungskompensationselement abfallende Kompensationsspannung so eingestellt ist, dass eine sehr schwache NULL bzw. sehr schwache EINS als Dateninhalt einer betroffenen Speicherzelle von der Schaltungsvorrichtung noch als digitale NULL bzw. EINS bewertet ist.

4. Schaltungsvorrichtung nach einem der Ansprüche 2 oder 3,
**dadurch gekennzeichnet,**
**dass** die Spannungskompensationselemente Transistoren (KT, KC) aufweisen, deren eine Elektrodenanschlüsse (Drain bzw. Source) mit benachbarten Bitleitungen gekoppelt sind, und deren andere Elektrodenanschlüsse (Drain bzw. Source) gemeinsam mit dem elektrischen Kompensationswiderstand verbunden sind.

5. Schaltungsvorrichtung nach einem der Ansprüche 1 bis 4,
**dadurch gekennzeichnet,**
**dass** die Transistoren (KT, KC) der Spannungskompensationselemente gleichzeitig Bestandteile der Sense-Verstärkereinrichtung (pSV, nSV) sind.

6. Schaltungsvorrichtung nach einem der Ansprüche 1 bis 5,
**dadurch gekennzeichnet,**
**dass** jede Speicherzelle (CZ) eine Zellkapazität (CK) und einen der Zellkapazität zugeordneten Auswahltransistor (CT) aufweist, dessen Elektrodenanschlüsse (Drain bzw. Source) jeweils an einer Bitleitungshälfte und dessen Steueranschluss (Gate) an einer Wortleitung angeschlossen ist.

7. Schaltungsvorrichtung nach einem der Ansprüche 1 bis 6,
**dadurch gekennzeichnet,**
**dass** die Sense-Verstärkereinrichtung einen p-Kanal- und einen n-Kanal-Sense-Verstärker aufweist.

## Claims

1. Circuit apparatus for evaluating the data content of memory cells (CZ) of an integrated semiconductor memory, which memory cells are arranged along bit lines (BL) and word lines (WL),
each bit line comprising a pair of complementary bit line halves (BT, BC), which are jointly connected to a sense amplifier device,
**characterized in that**
provision is made of a voltage compensation device (1) having voltage compensation elements (SKE) which are connected with the purpose of voltage coupling of in each case two neighbouring bit lines (BL),
the voltage compensation elements are connected to the complementary bit line halves of the two neighbouring bit lines.

2. Circuit apparatus according to Claim 1,
**characterized in that**
the voltage element (SKE) has an electrical compensation resistor (KW, KV) assigned to the two bit lines.

3. Circuit apparatus according to Claim 1 or 2,
**characterized in that**
the voltage compensation element (SKE) is designed and/or arranged and/or controlled in such a way, and thus the compensation voltage drop across the voltage compensation element is set in such a way, that a very weak ZERO or a very weak ONE as data content of a relevant memory cell is still evaluated as a digital ZERO or ONE by the circuit apparatus.

4. Circuit apparatus according to one of Claims 2 or 3,
**characterized in that**
the voltage compensation elements have transistors (KT, KC), whose first electrode terminals (drain and source) are coupled to neighbouring bit lines and whose second electrode terminals (drain and source) are jointly connected to the electrical compensation resistor.

5. Circuit apparatus according to one of Claims 1 to 4,
**characterized in that**
the transistors (KT, KC) of the voltage compensation elements are simultaneously parts of the sense amplifier device (pSV, nSV).

6. Circuit apparatus according to one of Claims 1 to 5,
**characterized in that**
each memory cell (CZ) has a cell capacitor (CK) and a selection transistor (CT) assigned to the cell capacitor, the electrode terminals (drain and source) of which transistor are respectively connected to a bit line half and the control terminal (gate) of which transistor is connected to a word line.

7. Circuit apparatus according to one of Claims 1 to 6,
**characterized in that**
the sense amplifier device has a p-channel sense amplifier and an n-channel sense amplifier.

## Revendications

1. Circuit pour l'évaluation du contenu de données de cellules de mémoire (CZ) d'une mémoire intégrée à semi-conducteurs, lesquelles cellules de mémoire sont disposées le long de lignes de bits (BL) et de lignes de mots (WL),
chaque ligne de bits étant constituée d'une paire de moitiés de ligne de bits (BT, BC) complémentaires qui sont raccordées ensemble à un dispositif amplificateur de lecture,
**caractérisé par le fait que**
il est prévu un dispositif compensateur de tension (1) comportant des éléments compensateurs de tension (SKE) qui sont branchés en vue d'un couplage, au niveau des tensions, de deux lignes de bits voisines (BL) à chaque fois,
les éléments compensateurs de tension étant raccordés aux moitiés de ligne de bits complémentaires des deux lignes de bits voisines.

2. Circuit selon la revendication 1,
**caractérisé par le fait que** l'élément compensateur de tension (SKE) comporte une résistance de compensation (KW, KV) électrique associée aux deux lignes de bits.

3. Circuit selon la revendication 1 ou 2,
**caractérisé par le fait que** l'élément compensateur de tension (SKE) est conçu ou disposé et/ou commandé de telle sorte, et donc la tension de compensation chutant à l'élément compensateur de tension est réglée, de telle sorte qu'un très faible ZERO ou un très faible UN comme contenu de données d'une cellule de mémoire considérée est encore évalué par le circuit respectivement comme un ZERO numérique et comme un UN numérique.

4. Circuit selon l'une des revendications 2 ou 3,
**caractérisé par le fait que** les éléments compensateurs de tension comportent des transistors (KT, KC) dont des premières bornes d'électrodes (drain ou source) sont couplées à des lignes de bits voisines et dont les autres bornes d'électrodes (drain ou source) sont reliées ensemble à la résistance électrique de compensation.

5. Circuit selon l'une des revendications 1 à 4,
**caractérisé par le fait que** les transistors (KT, KC) des éléments compensateurs de tension font en même temps partie du dispositif amplificateur de lecture (pSV, nSV).

6. Circuit selon l'une des revendications 1 à 5,
**caractérisé par le fait que** chaque cellule de mémoire (CZ) comporte une capacité de cellule (CK) et un transistor de sélection (CT), associé à la capacité de cellule, dont les bornes d'électrodes (drain respectivement source) sont raccordées à chaque fois à une moitié de lignes de bits et dont la borne de commande (grille) est raccordée à une ligne de mots.

7. Circuit selon l'une des revendications 1 à 6,
**caractérisé par le fait que** le dispositif amplificateur de lecture comporte un amplificateur de lecture à canal p et un amplificateur de lecture à canal n.
